# EUROPEAN PATENT SPECIFICATION

(11) **EP 4 057 785 B1**
(45) Date of publication and mention of the grant of the patent: **19.08.2026**
(21) Application number: 21161854.1
(22) Date of filing: 10.03.2021
(51) Int. Cl.: H05K 7/14

(54) **BUSBAR AND METHOD FOR MANUFACTURING A BUSBAR**
SAMMELSCHIENE UND VERFAHREN ZUR HERSTELLUNG EINER SAMMELSCHIENE
BARRE DE BUS ET PROCÉDÉ DE FABRICATION D'UNE BARRE DE BUS

(43) Date of publication of application: 14.09.2022
(73) Proprietor: Rogers BV, 9940 Evergem (BE)
(72) Inventor: Shi, Wei, 9940 Evergem (BE); Tang, Liang, 9940 Evergem (BE); Zhang, Yuqiang, 9940 Evergem (BE)
(74) Representative: Müller Schupfner & Partner Patent- und Rechtsanwaltspartnerschaft mbB (Muc)

(56) References cited:
- EP-A1- 3 599 676
- EP-A1- 3 654 742
- WO-A1-2019/235189
- CN-A- 107 425 320
- CN-U- 209 088 799
- US-A1- 2012 305 283
- US-A1- 2016 157 374
- US-B2- 8 934 999

## Description

The present invention concerns a busbar and a method for manufacturing a busbar, in particular a busbar on which several electronic components can be arranged.

Laminated busbars typically comprise layers of fabricated copper separated by thin dielectric materials, laminated to form a unified structure. Examples for laminated busbars can be found in CN 203 504 394 U, CN 104 022 414 A1 or CN 202 474 475 U. Usually a "plug-in" region is included into the busbar, in order to connect electrical poles of an electronic component, such as a capacitor directly to different conductive layers, wherein each of the conductive layers is assigned to a type of the poles provided by each capacitor. Typically, the capacitors are connected to the plug-in region by inserting a pin into an opening of the plug-in region. Subsequently, the pins are adhesively connected to the busbar, for example by soldering and/or welding.

CN 20 9088799 U and CN 209 088 799 U show a busbar having bent connectors for connecting connectors to them. EP 3 654 742 A1 concerns a method for manufacturing a busbar and forming a laser welding. EP 3 599 676 A1 discusses island like contact elements for mounting capacitors. US 8 934999 B2 concerns a robotic processing system. US 2016 015 7374 A1 discusses attaching a transistor to busbars.

Typically ,busbars that are mainly unstructured and, for example intended, for collecting and distributing electrical power, for example in an electric vehicle. Such a busbar forms a carrier for several electrical components, in particular connectors or capacitors, which can be arranged on a top side of the busbar. Typically, such busbars extend in a main extension plane and have a thickness, measured in a direction perpendicular to the main extension plane, of at least 1.5 mm.

For connecting a pin to a conductive layer of the busbar, soldering / welding techniques were established. However, soldering / welding requires storing heat inside the region, in which the soldering or welding actually takes place. Especially, due to a high thermal conductivity of the conductive layers, heat tends to dissipate away from the relevant location for realizing the welding / soldering seam, when a contact element is bonded to a busbar. As a consequence, the prior art knows busbars, having recesses in the conductive layer adjacent to or inside the plug-in region for interrupting the heat transfer or reducing the heat transfer away from the plug-in region. However, such recesses influence the electric properties of the conductive layer of the busbar. Furthermore, such recesses require a specific design, especially for providing a sufficient large free space such that a soldering iron has access to the welding zone.

Considering the above, it is an object if the present invention to improve the soldering or welding mechanism, which connects a pin or contact element to a busbar, especially in case of a mass production of such connections.

This object is achieved by an arrangement according to claim 1 and a method according to claim 12. Preferred embodiments are incorporated in the dependent claims, the description and the figures.

According to the present invention an arrangement of a busbar and an electric component is provided. The busbar, in particular a laminated busbar, of the arrangement is configured for mounting an electronic component on the busbar, in particular a passive electronic component. The busbar comprises
- at least one plug-in region for inserting a contact element of the electronic component, in particular a pin of the electronic component, into the busbar and
- a first conductive layer, extending parallel to a main extension plane of the busbar outside the at least one plug-in region,
wherein within the at least one plug-in region the first conductive layer has a first connection section, which is bonded to the contact element in a mounted state, wherein the first connection section extends in a direction being slanted, preferably being perpendicular, to the main extension plane.

Contrary to the prior art, it is provided to use a first connection section, which is located inside the plug-in region, the connection section being slanted relative to the general course of the first conductive layer. It turned out that this arrangement or orientation of the first connection section is an alternative way to store heat, being produced and used during the welding or soldering process. Especially, the desired storage of the heat energy is caused by the reduced contact between the pin or contact element on the one hand and the first connection section on the other hand. As a result, it is possible to avoid recesses being incorporated into the first conductive layer otherwise for interrupting the heat transfer. As a result, it is advantageously possible to avoid affecting the electric properties of the first conductive section or conductive layer and furthermore to effectively produce the welding or soldering connection by a reduced amount of energy. Furthermore, the protruding first connection section simplifies the access for a soldering iron or any other means for soldering or welding the contact element to the first connection section. The simplified access allows even using welding techniques, which are used in mass production, for example by soldering several busbars to respective connect electric components simultaneously, for example by using a soldering wave technique.

Preferably, the busbar is a flat product extending in a main extension plane. The term "flat" means that a thickness of the busbar, measured in a direction perpendicular to the main extension plane, is at least 10 times, preferably at least 15 times, smaller than the extensions across the busbar in a plane parallel to the main extension plane. For instance, the busbar is laminated and/or covered with an insulation layer. It is also provided that the busbar comprises at least one first conductive layer and/or at least a second conductive layer that are separated from each other by a insulation layer, wherein the at least first conductive layer, the at least second conductive layer and the further insulation layer are stacked above each other in the stacking direction, being perpendicular to the main extension plane. Such busbars are particularly intended for collecting and transferring electrical power. For example, a plurality of capacitors is arranged on top of the busbar and are connected to the busbar for distributing a total power collected from a plurality of capacitors. Such busbars are intended for being used in electrical vehicles, for example. Preferably, the at least one first conductive layer and/or the at least second conductive layer is made from a metal, such as copper, steel or aluminium. In particular, the thickness of the busbar, measured in a direction perpendicular to the main extension plane, is between 0.5 mm and 6 mm, more preferably between 0.5 mm and 2 mm or between 4.5 and 5.5 mm. It is also conceivable that the busbar is bended or shaped in a defined way for being adapted to its application location.

Preferably the plug in region includes an opening and an area being arranged directly adjacent to the opening and extending 20 mm, preferably 10 mm and more preferably 5 mm from the opening.

According to a preferred embodiment, it is provided that the busbar comprises a second conductive layer extending outside the at least one plug-in region parallel to a main extension plane of the busbar, wherein within the at least one plug-in region the second conductive layer has a second connection section, which is bonded to a further contact element, preferably a further pin, in the mounted state, wherein the second connection section extends in the direction being slanted, preferably being perpendicular to the main extension plane. In particular, it is provided that the contact element and the further contact element are assigned to the same electric component such that it is possible to assign a positive pole to the contact element and a negative pole to a further contact element in case of a capacitor, being the electric component. Preferably, it is provided that the first and second conductive layer are connected to the pin or the further pin in the same or common plug-in region. Alternatively, it is also conceivable that the plug-in region or the first connection section are spaced from the plug-in region for the second connection section such that between the both plug-in regions a region exists in which both the first and the second conductive layer extend parallel to the main extension plane.

Furthermore, it is preferably provided than an insulation layer is arranged between the first conductive layer and the second conductive layer. Due to the insulation layer it is possible to isolate the first conductive layer from the second conductive layer, electronically. In particular, it is provided that the insulation layer is sandwiched between the first conductive layer and the second conductive layer. Furthermore, it is provided that the first conductive layer and the second conductive layer have terminals, which mainly extends parallel to the main extension plane from the first conductive layer and/or the second conductive layer.

Preferably, it is provided that a ratio of the length of the first connection section to the length of a contact element is between 0.6 and 1, preferably between 0.75 and 1 and most preferably between 0.9 and 1. Such a ratio guarantees that the first conduction section mainly extends parallel to the whole extension of the contact element. As a result, it is possible to realize a small contact between the pin and the first connection section, which extends over a certain distance. The same applies for the second connection section and the further contact element, i. e. the further pin. Preferably, it is provided that the first length and the second length are measured in a direction, being perpendicular to the main extension plane.

Preferably, the first conductive layer and/or the second conductive layer are free from recesses, in particular within the plug-region.

In particular, it is provided that the first conductive and/or second conductive layer are mainly L-shaped in the plug-in region and preferably formed by bending the first conductive layer/second conductive layer in the plug-in region. It is conceivable that for producing the first and/or second conductive connection section, a strip is realised in the first conductive layer and the second conductive layer and subsequently the strip is bended to form the first connection section and/or the second connection section.

Preferably, it is provided that the plug-in region comprises an opening for passing the contact element through the busbar and preferably a further opening for passing the further contact element through the busbar. In other words: The contact element and the further contact element reach through the busbar for being welded to the first connection section and second connection section on a side of the busbar being opposite to the location of the electronic component, i. e. preferably opposite to the capacitor. This simplifies the access to the region, which has to be soldered by corresponding means for soldering, such as a soldering iron.

Preferably, it is provided that the opening and the further opening are located between the first connection section and the second connection section, in particular in a plane being parallel to the main extension plane. In other words: In a mounted state the pin and the further pin are sandwiched between the first connection section and the second connection section in a plane being parallel to the main extension plane.

Preferably, it is provided that the busbar has at least one further insulation layer at an outside of the first conductive layer and/or the second conductive layer. As a consequence, it is possible to completely insulate the busbar and for example arrange the busbar at its place of application without any need of an additional housing. Furthermore, it is possible to bend the busbar for matching the shape for its place of application.

Preferably, it is provided that the first connection section includes a first subsection protruding from the busbar over a third length in a direction being perpendicular to the main extension plane, wherein in the third length is at least 1 mm, preferably is between 2 and 3 mm. It turned out that by establishing a third length of at least 1 mm almost all soldering techniques can be applied for connecting the pin to the connection section without the need for a further modification of the first or second conductive layer. In the case of a third length of 2 to 3 mm, it is even possible to use techniques that allow the simultaneous welding process of several busbars, the busbars being connected to the electric components at the welding connection between the first connection section or second connection section to the pin or the further pin.

Another subject matter of the present invention is an arrangement of a busbar according to the present invention and an electric component, wherein the contact element of the electronic component is bonded to the first connection section, preferably materially by a soldering/welding seam. All benefits and specifications being discussed and mentioned in context of the busbar apply analogously to the arrangement and vice versa.

According to the invention, the contact element and the first connection section contact each other along a line. By using specific cross sections of the first / second connection section and the contact element respectively the contact can be reduces in an advantageous manner.

According to another preferred embodiment, a first cross section of the first connection section in the plane parallel to the main extension plane is larger than a second cross section of the contact element in the plane parallel to the main extension plane. Preferably, the first cross section of the first connection section differs from the second cross section of the contact element with respect to its shape and/or size. As a result, it is possible to create a really small contact area between the contact element and the connection section for improving storing heat and therefore the efficiency of bonding via a welding or a soldering mechanism. For example, it is provided that the pin or further pin is formed by a circular shape in the plane being parallel to the main extension plane, while the first connection section has a rectangular cross section.

Especially, a ratio of a size of the second cross section to a size of the first cross section is between 0.01 and 0.5, preferably between 0.01 and 0.25 and most preferably between 0.01 and 0.1.

Preferably, it is provided that the contact element and the further contact element are located between the first connection section and the second connection section. Such an arrangement preferably applies in such cases, in which the first pin or the further pin share the same plug-in region.

It is further conceivable that the connection between the first connection section and the second connection section to the contact element and the further contact element is supported at least by a force fit along a direction being perpendicular to the main extension plane, such as a press fit mechanism, for example, by choosing a corresponding elasticity for the contact element and the further contact element and by adapting the dimensions of the first connection section and the second connection section, compared to the distance between the contact element and the further contact element in a direction being parallel to the main extension plane.

Another subject matter of the present invention is a method for connecting an electric component to a busbar, in particular a busbar according to the present invention, for forming an arrangement according to the present invention. All benefits and specifics, being discussed in context of the arrangement and the busbar apply analogously for the method and vice versa.

Preferably, it is provided that the contact element of an electronic component is inserted into a plug-in region of the busbar, wherein the contact element is soldered or welded to the plug-in region, preferably automatically by a robot. Especially, the dimensioning of the third length allows automatic welding and soldering by using a robot. In particular, the implementation of such a robot, which allows the automatization of the soldering or welding mechanism, is simplified by the corresponding third length.

Preferably, it is provided that several contact elements are soldered and/or welded simultaneously. For example, a soldering wave technique is used for connecting several contact elements to first connection sections of several busbars by placing them in a common bath and applying the well-known welding technique. As a consequence, it is possible to create a large number of welding seams in a comparable short time including the efficiency of creating the mounted arrangement.

Preferably, it is provided that the contact element is bonded to the first connection section by wave soldering, resistance soldering, iron hand soldering and/or Tig welding.

Wherever not already described explicitly, individual embodiments or their individual aspects and features can be combined or exchanged with one another without limiting or widening the scope of the described invention, whenever such a combination or exchange is meaningful and in the sense of this invention. Advantages which are described with respect to one embodiment of the present invention are, wherever applicable, also advantageous of other embodiments of the present invention.

In the drawings:
- **Fig. 1**: schematically shows a perspective view on a busbar for a method according to the present invention and
- **Fig. 2**: schematically shows a side view of the busbar from figure 1,

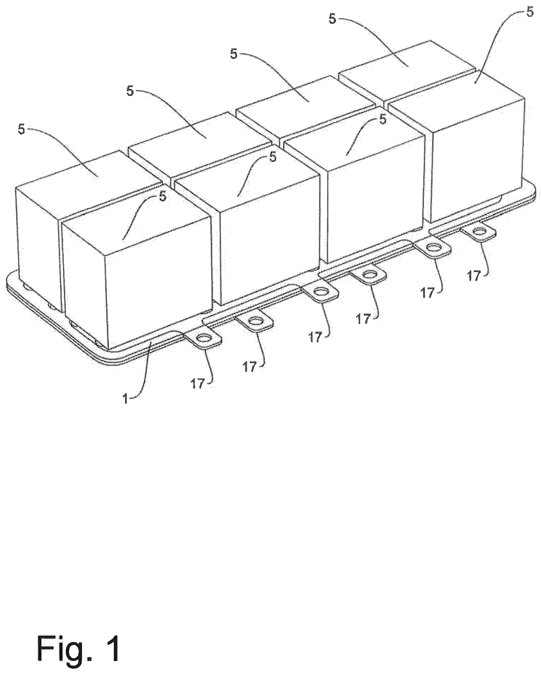

In **Figure 1****,** a busbar 1 is illustrated according to an exemplary embodiment of the present invention. In particular, the busbar 1 is designed as a laminated busbar, comprising at least a first conductive layer 10 and a second conductive layer 20 that are separated by at least one insulation layer 15. Both the first conductive layer 10 and the second conductive layer 20 are provided to collect and to conduct a current caused by several capacitors 5 being arranged on the busbar 1 and respectively connected to the first conductive layer 10 and the second conductive layer 20.

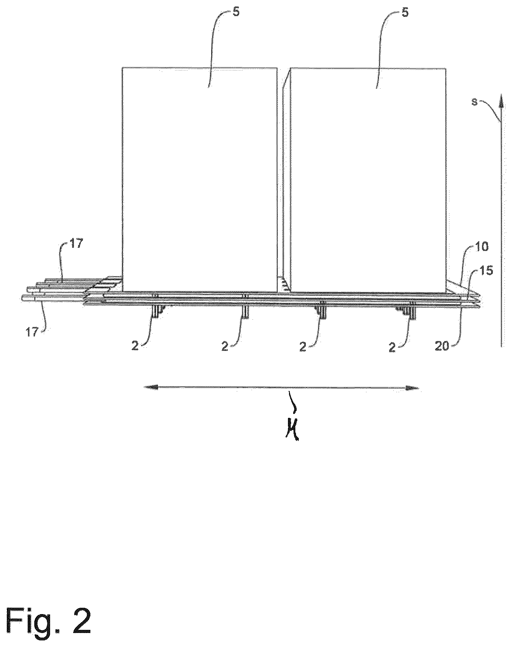

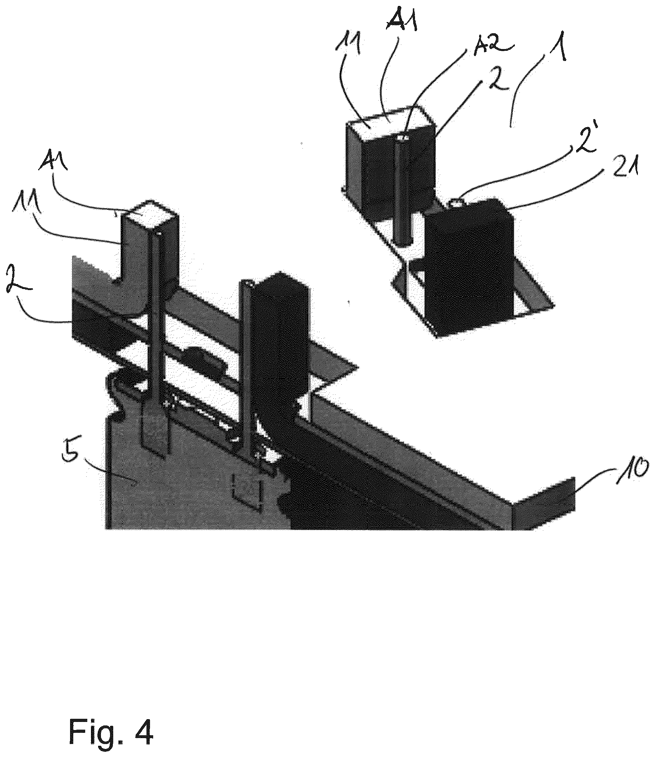

Especially, the first conductive layer 10 and/or the second conductive 20 layer are made out of a metal, in particular copper and/or aluminium. Preferably, the first conductive layer 10, the second conductive layer 20 and the insulation layer 15 are extending parallel to each other and are stacked on each other along a stacking direction S being perpendicular to a main extending plane M (Fig. 2). In the illustrated embodiment there are eight capacitors 5 being located on the busbar 1. The first conductive layer 10 and the second conductive layer 20 are respectively connected to one electrical pole of each of the capacitors 5. For providing the electrical power, the first conductive layer 10 and/or the second conductive layer 20 each comprise at least one terminal 17 for delivering a certain voltage provided by the capacitor arranged on the busbar 1. Further, it is provided that the first conductive layer 10 extends in a first plane and preferably the corresponding terminal 17 of the first conductive layer 10 extends in the first plane, too (Fig. 4b).

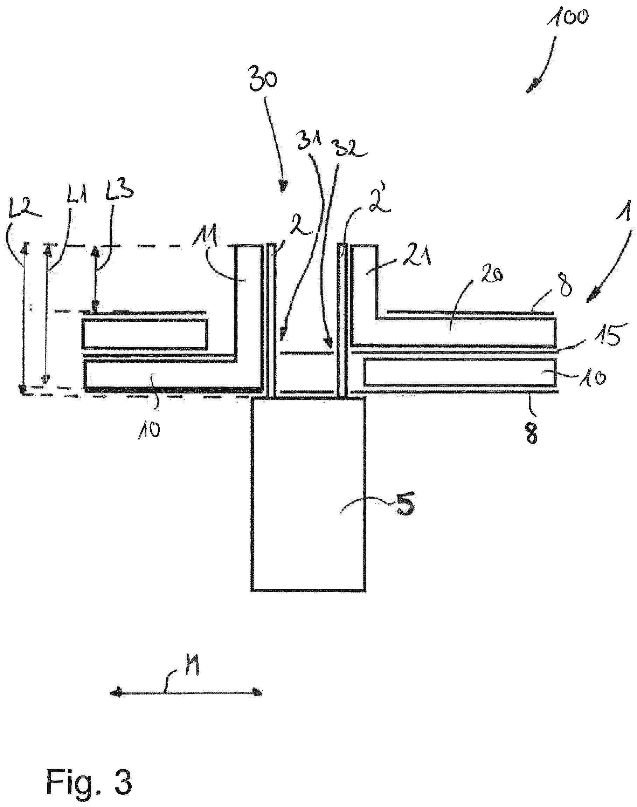

In **Figure 2****,** a side view of the busbar 1 having the capacitors 5 being arranged on the busbar 1 is illustrated. As illustrated the connection between each capacitor 5 and respectively the first conductive layer 10 and the second conductive layer 20 is realized by pins 2. Preferably, each capacitor 5 has a pin 2 assigned to a positive pole of the capacitor 5 and a pin 2 assigned to a negative pole of the capacitor 5. Both pins 2 reach through the busbar 1, wherein one pin 2 of each capacitor 5 is connected to the first conductive layer 10 and the other pin 2 is connected to the second conductive layer 20. For example, it is provided that all negative poles are connected to the first conductive layer 10 and all positive poles of the capacitors 5 are connected to the second conductive layer 20. For connecting the respective pins 2 to the first conductive layer 10 and the second conductive layer 20, plug-in regions 30 are provided (Fig. 3). Preferably, for each pin 2 one plug-in region 30 is provided or one common plug-in region is provided for both pin, being assigned to the positive pole and the negative pole respectively. The plug-in region 30 comprises an opening 31 so that the pin 2 can be inserted into the opening 31 by a movement in a direction perpendicular to the first plane and/or parallel to the stacking direction S. In the case of a cylindrical pin, the opening 31 might have a circular shape. It is also conceivable that the pin 2 has a rectangular cross section and the opening 31 is formed rectangular in the same form. Preferably, the opening 31 and the cross section of the pin 2 are realized according to a key-lock principle.

For bonding or fixing the pin 2 to the busbar 1, in particular to the first conductive layer 10, soldering or welding is used. However, soldering or welding the contact element to the first conductive layer 1 is challenging, since heat, being generated during the soldering or welding mechanism, is led away due to the thermal conductivity of the first conductive layer 10. As a result, it is difficult to store heat in the area, in which thermal energy is needed for the melting, which is necessary for forming the weld / soldering seam. Therefore, the prior art suggests, for example, recesses being incorporated into the first conductive layer 10 and/or the second conductive layer 20, which interrupt the heat energy transfer away from the section, in which the welding or soldering seam has to be generated. However, such recesses reduce the electric conductivity of the busbars 1 and influence the electric properties of the first conductive layer 10 and/or the second conductive layer 20.

In **figure 3** an arrangement of a busbar 1 and an electric component, in particular a capacitor 5, is shown according to a preferred embodiment of the present invention. In particular, it is provided that the first conductive layer 10 extends mainly parallel to the main extension plane M outside of the plug-in region 30. Inside the plug-in region 30 the first conductive layer 10 has a first connection section 11, which extends slanted, in particular perpendicular to the main extension plane M. Preferably, the first conductive section 10 is formed by a bended section of the first conductive layer 10 inside of the plug-in region 30. Furthermore, it is provided in the embodiment of figure 3 that a further pin 2' is attached to the second conductive layer 20 in a common, i. e. the same plug-in region 30. Alternatively, it is also conceivable that the further pin 2' is connected to the second conductive layer 20 in a plug-in region 30, being spaced from the plug-in region 30 being intended for the first conductive layer 10.

Furthermore, it is preferably provided that the second conductive layer 20 has a second connection 21 section, which extends slanted, in particular perpendicular, to the main extension plane M, while the second conductive layer 20 extends mainly parallel to the main extension plane M outside of the plug-in region 30. In analogy to the first conductive layer 10, the second connection section 20 is preferably formed by bending the second conductive layer 20 in the plug-in region 30 such that the second connection section 20 is slanted or even perpendicular to the main extension plane M. As a result of the orientation of the first connection section 11 and/or the second connection section 21, the first connection section 11 and/or the second connection section 21 extends mainly parallel to the pin 2 or the further pin 2' in a mounted state of the electric component. Especially, the pin 2 and/or further pin 2' contacts only a single side of the first connection section 11 or the second connection section 21, respectively. It turned out that it is possible to reduce the contact between the pin 2 and the first connection section 11 or the further pin 2' and the second connection section 21 compared to the connection of the pin 2 to a simple through-hole. As a consequence, it is possible to store heat in the region, in which the welding seam or soldering seam has to be generated. As result of the storing heat energy, the soldering and welding process can be improved and made more efficient. At the same time, it is not necessary to introduce recesses inside the first conductive layer 10 and/or the second conductive layer 20, which might have a negative effect on the electric properties of the first conductive layer 10 and the second conductive layer 20.

Another disadvantage of using a first conductive layer 10 and the second conductive layer 20 having a recess for interrupting the heat transport, is the need of providing space for a soldering iron 40, which needs to have access to the region, in which the soldering has to be realised.

Furthermore, it is provided that the busbar 1 has an opening 31 for passing the pin 2 through the busbar 1 and/or has a further opening 32 for inserting the further pin 2' into the busbar 1. Especially, it is provided that the first connection section 11 and the second connection section 21 are located on a side of the busbar 1 facing away from the electric component, in particular of the capacitor 5. Therefore, it is necessary that the pin 2 or the further pin 2' passes through the opening 31 and the further opening 32 for getting into contact with the first connection section 11 and/or the second connection section 21, protruding from the busbar in a direction facing away from the electric component.

Furthermore, it is provided that the first connection section 11 has a first length L1, measured in a direction being perpendicular to the main extension plane M, and the pin 2 and/or further pin 2' has a second length L2, measured in a direction being perpendicular to the main extension plane M. Especially, a ratio between the first length L1 to the second length L2 has a value between 0.6 and 1, preferably between 0.75 and 1 and most preferably 0.9 and 1. As a result, it is possible to create a comparable large region, in which the pin 2 or the further pin 2' is in contact with the first conductive layer 10 and/or the second conductive layer 20. Furthermore, it is provided that the first connection section 11 and/or the second connection section 21 protrudes from an outside of the busbar 1, measured in a direction being perpendicular to the main extension plane M over a third length L3, the third length L3 being at least 1 mm. Especially, it turned out that providing a protruding subsection of the first connection section 11 and/or the second connection section 21, allows using several advantageous welding and soldering mechanism for bonding the first contact section 11 to the pin 2, effectively. Preferably, the third length L3 has a value between 2 to 3 mm.

Furthermore it is provided that the first conductive layer 10 and the second conductive layer 20 are spaced from each other and between the first conductive layer 10 and the second conductive layer 20, in particular outside of the plug-in region 30, an insulation layer 15 is arranged. Furthermore, it is provided that a further insulation layer 8 is located at the outside of the busbar 1, preferably at the outer side of the busbar 1, facing away from the electric component or facing to the electric component.

In **figure 4** two plug-in regions 30 according to a further preferred embodiment are shown in a perspective view. In particular, it is shown that the first connection section 11 and/or the second connection section 21 has a first cross section A1 while the pin 2 and/or the further pin 2' have a second cross section A2, wherein the first cross section A1 and the second cross section A2 differs from each other regarding their size and/or shape. For example, the first connection section 10 and/or the second connection section 20 has a mainly rectangular cross section in a plane parallel to the main extension plane M, while the pin 2 and/or further pin 2' has a circular cross action. As a consequence, a contact between the connection section 11 and the pin 2 is further reduced.

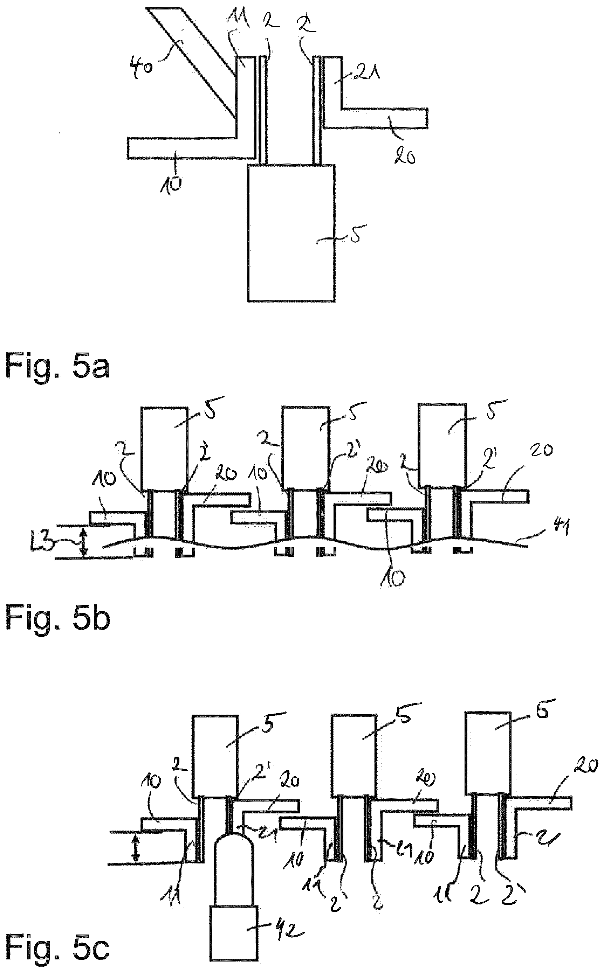

In the **figures 5a to 5e****,** several different ways of soldering and welding the pin 2 to the first connection section 11 are shown. For example, figure 5a illustrates using a soldering iron 40 for realising the desired connection between the first connection section 11 and the pin 2.

The method illustrated in figure 5b refers to a wave soldering mechanism. The wave soldering mechanism uses a fluid 41, being affected by an ultrasound source, wherein the first connection section 11 and the second connection section 21 as well as the pin 2 and the further pin 2', are inserted inside the fluid 41 and several connections of preferably different busbars 1 are realised to the capacitors 5 or the electric components.

In figure 5c, a selective wave soldering is illustrated according to which an individual soldering or welding is performed for the first connection section and the pin 2 by a means for individualized soldering 42. It turned out that for using a wave soldering or a selective wave soldering, it is of advantage to have a third length L3 of about 2 to 3 mm.

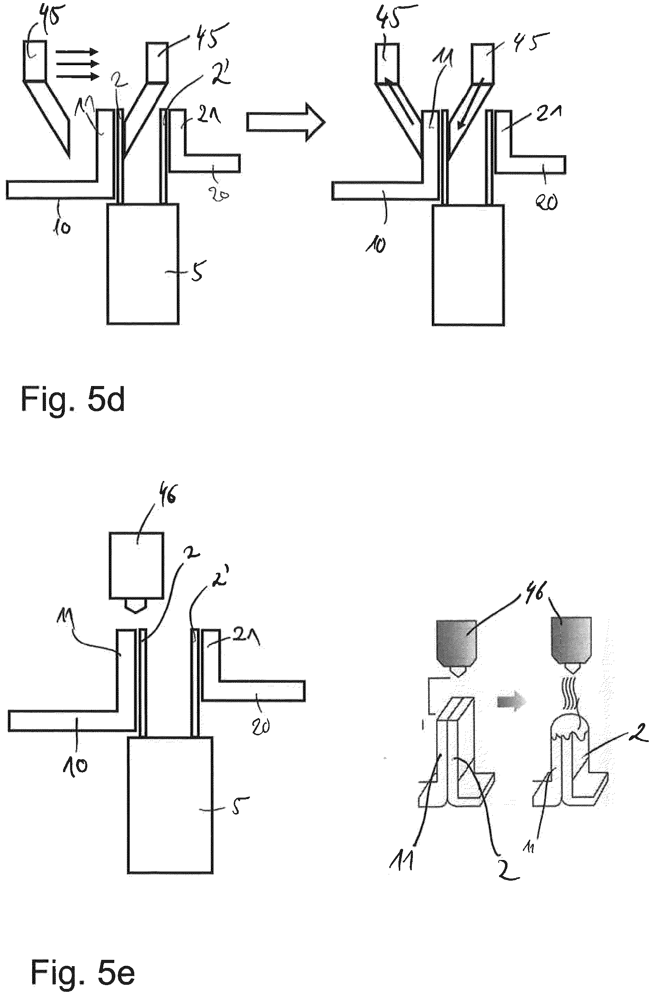

Figure 5d shows a method for bonding the pin 2 to the first connection section 11 by resistance welding. For performing the resistance welding, the first connection section 11 and the pin 2 are clamped between two clamping elements 43. After establishing a sufficient clamping, a current is established which passes through the clamped first connection section 11 and the pin 2. As a result of the established current and the realized heat, the soldering or welding is performed.

Another alternative for welding the pin 2 to the first connection section 11 is illustrated in figure 5e, which shows a tip welding. The tip welding uses a probe 44 which is placed on top of the section of the planned welding or soldering seam. After spacing or locating the probe 44 in a distance of about 1 to 2 mm from the first connection 11 section and the pin 2, it is possible to melt the top front sides, i. e. the tips of the first connection section 11 and the pin 2, for establishing the welding seam or soldering seam, as is illustrated on the right side of figure 5e.

### Reference sigs:

- 1: busbar
- 2: pin
- 2': further pin
- 5: capacitor
- 7: insulation layer
- 8: further insulation layer
- 10: first conductive layer
- 11: first connection section
- 20: second conductive layer
- 21: second connection section
- 30: plug-in region
- 31: opening
- 32: further opening
- 40: soldering iron
- 41: fluid
- 42: means for individualized soldering
- 43: clamping element
- 44: probe
- 100: arrangement
- M: main extension plane
- L1: first length
- L2: second length
- L3: third length
- A1: cross section
- A2: further cross section
- S: stacking direction

## Claims

1. An arrangement (100) of a busbar (1) and an electronic component (5) ,
wherein the busbar (1) comprises :
- at least one plug-in region (30) for inserting a contact element (2) of the electronic component (5), in particular a pin of the electronic component (5), into the busbar (1) and
- a first conductive layer (10), extending parallel to a main extension plane (M) of the busbar (1) outside the at least one plug-in region (30),
wherein the first conductive layer (10) comprises a first connection section (11) within the at least one plug-in region (30), the first connection section (11) being bonded to the contact element (2) in a mounted state, wherein the first connection section (11) extends in a direction being slanted, preferably being perpendicular, to the main extension plane (M), **characterized in that** the contact element (2) and the first connection section (11) contact each other along a line.

2. The arrangement (100) according to claim 1, wherein the busbar further comprises:
- a second conductive layer (20), extending parallel to a main extension plane of the busbar (1) outside the at least one plug-in region (30),
wherein the second conductive layer (20) comprises a second connection section (21) within the at least one plug-in region (30), the second connection section (21) being bonded to a further contact element, in particular to a further pin (2'), in the mounted state, wherein the second connection section (21) extends in a direction being slanted, preferably being perpendicular, to the main extension plane (M).

3. The arrangement (100) according to claim 2, wherein the further contact element (2') and the second connection section (21) contact each other along a line.

4. The arrangement (100) according to one of the preceding claims , wherein the contact element is a pin and the pin is formed by a circular shape in a plane being parallel to the main extension plane (M), while the first connection section (11) has a rectangular cross section.

5. The arrangement (100) according to one of the preceding claims, wherein a ratio of a first length (L1) of the first connection section (11) to a second length (L2) of a contact element is between 0.6 and 1, preferably between 0.75 and 1 and most preferably between 0.9 and 1.

6. The arrangement (100) according to one of the preceding claims, wherein the plug-in region (30) comprises an opening (31) for passing the contact element through the busbar (1) and preferably a further opening (32) for passing the further contact element through the busbar (1).

7. The arrangement (100) ) according to claim 6, wherein the opening (31) and the further opening (32) are located between the first connection section (11) and the second connection section (21).

8. The arrangement (100) according to one of the preceding claims, wherein the busbar (1) has at least one further insulation layer (8) at an outer side of the first conductive layer (10) and/or the second conductive layer (20).

9. The arrangement (100) according to one of the preceding claims, wherein the first connection section (11) has a first subsection protruding from the busbar (1) over a third length (L3), measured in a direction being perpendicular to the main extension plane (M), wherein the third length (L3) is at least 1 mm, preferably between 2 mm and 3 mm.

10. The arrangement (100) according to one of the preceding claims, wherein a first cross section (A1) of the first connection section (11) in a plane parallel to the main extension plane (M) is greater as a second cross section (A2) of the contact element in a plane parallel to the main extension plane (M).

11. The arrangement of claim 10, wherein the contact element and the further contact element are located between the first connection section (11) and the second connection section (21).

12. A Method for connecting an electrical component to a busbar (1) for forming an arrangement (100) according to one of the preceding claims.

13. The method according to claims 12, wherein a contact element of an electronic component is inserted into a plug-in region (30) of the busbar (1), wherein the contact element is soldered and/or welded to the connection section (11), preferably automatically by a robot.

14. The method according to one of the claims 12 or 13, wherein several contact elements are soldered and/or welded simultaneously.

15. The method according to one of the claims 12 to 14, wherein the contact element is bonded to the first connection section (11) by wave soldering, resistance soldering, iron hand soldering and/or tip welding.

## Patentansprüche

1. Anordnung (100) aus einer Stromsammelschiene (1) und einem elektronischen Bauteil (5), wobei die Stromsammelschiene (1) aufweist:
- mindestens einen Steckbereich (30) zum Einstecken eines Kontaktelements (2) des elektronischen Bauteils (5), insbesondere eines Stifts des elektronischen Bauteils (5), in die Stromsammelschiene (1) und
- eine erste leitende Schicht (10), die sich parallel zu einer Haupterstreckungsebene (M) der Stromsammelschiene (1) außerhalb des mindestens einen Steckbereichs (30) erstreckt,
wobei die erste leitende Schicht (10) einen ersten Verbindungsabschnitt (11) innerhalb des mindestens einen Steckbereichs (30) aufweist, wobei der erste Verbindungsabschnitt (11) im montierten Zustand mit dem Kontaktelement (2) verbunden ist, wobei sich der erste Verbindungsabschnitt (11) in einer Richtung erstreckt, die zur Haupterstreckungsebene (M) geneigt, bevorzugt senkrecht zu dieser ist, **dadurch gekennzeichnet, dass** das Kontaktelement (2) und der erste Verbindungsabschnitt (11) entlang einer Linie miteinander in Kontakt stehen.

2. Anordnung (100) gemäß Anspruch 1, wobei die Stromsammelschiene ferner umfasst:
- eine zweite leitende Schicht (20), die sich außerhalb des mindestens einen Steckbereichs (30) parallel zu einer Haupterstreckungsebene der Stromsammelschiene (1) erstreckt,
wobei die zweite leitende Schicht (20) einen zweiten Verbindungsabschnitt (21) innerhalb des mindestens einen Steckbereichs (30) aufweist, wobei der zweite Verbindungsabschnitt (21) im montierten Zustand mit einem weiteren Kontaktelement, insbesondere mit einem weiteren Stift (2'), verbunden ist, wobei sich der zweite Verbindungsabschnitt (21) in einer Richtung erstreckt, die schräg, bevorzugt senkrecht, zur Haupterstreckungsebene (M) verläuft.

3. Anordnung (100) gemäß Anspruch 2, wobei das weitere Kontaktelement (2') und der zweite Verbindungsabschnitt (21) entlang einer Linie miteinander in Kontakt stehen.

4. Anordnung (100) gemäß einem der vorherigen Ansprüche, wobei das Kontaktelement ein Stift ist und der Stift durch eine kreisförmige Form in einer zur Haupterstreckungsebene (M) parallelen Ebene gebildet ist, während der erste Verbindungsabschnitt (11) einen rechteckigen Querschnitt aufweist.

5. Anordnung (100) gemäß einem der vorherigen Ansprüche, wobei das Verhältnis einer ersten Länge (L1) des ersten Verbindungsabschnitts (11) zu einer zweiten Länge (L2) eines Kontaktelements zwischen 0,6 und 1, bevorzugt zwischen 0,75 und 1 und besonders bevorzugt zwischen 0,9 und 1 liegt.

6. Anordnung (100) gemäß einem der vorherigen Ansprüche, wobei der Steckbereich (30) eine Öffnung (31) zum Durchführen des Kontaktelements durch die Stromsammelschiene (1) und bevorzugt eine weitere Öffnung (32) zum Durchführen des weiteren Kontaktelements durch die Stromsammelschiene (1) aufweist.

7. Anordnung (100) gemäß Anspruch 6, wobei sich die Öffnung (31) und die weitere Öffnung (32) zwischen dem ersten Verbindungsabschnitt (11) und dem zweiten Verbindungsabschnitt (21) befinden.

8. Anordnung (100) gemäß einem der vorherigen Ansprüche, wobei die Stromsammelschiene (1) an einer Außenseite der ersten leitenden Schicht (10) und/oder der zweiten leitenden Schicht (20) mindestens eine weitere Isolierschicht (8) aufweist.

9. Anordnung (100) gemäß einem der vorherigen Ansprüche, wobei der erste Verbindungsabschnitt (11) einen ersten Unterabschnitt aufweist, der über eine dritte Länge (L3) - gemessen in einer Richtung senkrecht zur Haupterstreckungsebene (M) - aus der Stromsammelschiene (1) herausragt, wobei die dritte Länge (L3) mindestens 1 mm, bevorzugt zwischen 2 mm und 3 mm beträgt.

10. Anordnung (100) gemäß einem der vorherigen Ansprüche, wobei ein erster Querschnitt (A1) des ersten Verbindungsabschnitts (11) in einer zur Haupterstreckungsebene (M) parallelen Ebene größer ist als ein zweiter Querschnitt (A2) des Kontaktelements in einer zur Haupterstreckungsebene (M) parallelen Ebene.

11. Anordnung nach Anspruch 10, wobei das Kontaktelement und das weitere Kontaktelement zwischen dem ersten Verbindungsabschnitt (11) und dem zweiten Verbindungsabschnitt (21) angeordnet sind.

12. Verfahren zum Anschließen eines elektrischen Bauteils an eine Stromsammelschiene (1) zur Bildung einer Anordnung (100) gemäß einem der vorherigen Ansprüche.

13. Verfahren gemäß Anspruch 12, wobei ein Kontaktelement eines elektronischen Bauteils in einen Steckbereich (30) der Stromsammelschiene (1) eingeführt wird, wobei das Kontaktelement mit dem Verbindungsabschnitt (11) verlötet und/oder verschweißt wird, bevorzugt automatisch durch einen Roboter.

14. Verfahren gemäß einem der Ansprüche 12 oder 13, wobei mehrere Kontaktelemente gleichzeitig gelötet und/oder geschweißt werden.

15. Verfahren gemäß einem der Ansprüche 12 bis 14, wobei das Kontaktelement durch Wellenlöten, Widerstandsschweißen, Handlöten mit Lötkolben und/oder Punktlöten mit dem ersten Verbindungsabschnitt (11) verbunden wird.

## Revendications

1. Ensemble (100) constitué d'une barre omnibus (1) et d'un composant électronique (5), la barre omnibus (1) comprenant :
- au moins une zone d'enfichage (30) destinée à l'insertion d'un élément de contact (2) du composant électronique (5), en particulier d'une broche du composant électronique (5), dans la barre omnibus (1) et
- une première couche conductrice (10), s'étendant parallèlement à un plan d'extension principale (M) de la barre omnibus (1) à l'extérieur de ladite au moins une zone d'enfi-chage (30),
dans lequel
la première couche conductrice (10) comprend une première section de connexion (11) à l'intérieur de ladite au moins une zone d'enfichage (30), la première section de connexion (11) étant reliée à l'élément de contact (2) à l'état monté, la première section de connexion (11) s'étendant dans une direction oblique, de préférence perpendiculaire, par rapport au plan d'extension principale (M),
**caractérisé en ce que** l'élément de contact (2) et la première section de connexion (11) sont en contact l'un avec l'autre le long d'une ligne.

2. Ensemble (100) selon la revendication 1,
la barre omnibus comprenant en outre :
- une deuxième couche conductrice (20), s'étendant parallèlement à un plan d'extension principale de la barre omnibus (1) à l'extérieur de ladite au moins une zone d'enfichage (3),
dans lequel
la deuxième couche conductrice (20) comprend une deuxième section de connexion (21) à l'intérieur de ladite au moins une zone d'enfichage (30), la deuxième section de connexion (21) étant reliée à un autre élément de contact, en particulier à une autre broche (2'), à l'état monté, la deuxième section de connexion (21) s'étendant dans une direction oblique, de préférence perpendiculaire, par rapport au plan d'extension principale (M).

3. Ensemble (100) selon la revendication 2,
dans lequel l'autre élément de contact (2') et la deuxième section de connexion (21) sont en contact l'un avec l'autre le long d'une ligne.

4. Ensemble (100) selon l'une des revendications précédentes,
dans lequel l'élément de contact est une broche et la broche présente une forme circulaire dans un plan parallèle au plan d'extension principale (M), tandis que la première section de connexion (11) présente une section transversale rectangulaire.

5. Ensemble (100) selon l'une des revendications précédentes,
dans lequel le rapport d'une première longueur (L1) de la première section de connexion (11) sur une deuxième longueur (L2) d'un élément de contact est compris entre 0,6 et 1, de préférence entre 0,75 et 1 et, de manière encore plus préférée, entre 0,9 et 1.

6. Ensemble (100) selon l'une des revendications précédentes,
dans lequel la zone d'enfichage (30) comprend une ouverture (31) permettant le passage de l'élément de contact à travers la barre omnibus (1) et, de préférence, une autre ouverture (32) permettant le passage de l'autre élément de contact à travers la barre omnibus (1).

7. Ensemble (100) selon la revendication 6,
dans lequel l'ouverture (31) et l'autre ouverture (32) sont situées entre la première section de connexion (11) et la deuxième section de connexion (21).

8. Ensemble (100) selon l'une des revendications précédentes,
dans lequel la barre omnibus (1) comprend au moins une autre couche isolante (8) sur une face extérieure de la première couche conductrice (10) et/ou de la deuxième couche conductrice (20).

9. Ensemble (100) selon l'une des revendications précédentes,
dans lequel la première section de connexion (11) comprend une première sous-section faisant saillie de la barre omnibus (1) sur une troisième longueur (L3), mesurée dans une direction perpendiculaire au plan d'extension principale (M), la troisième longueur (L3) étant d'au moins 1 mm, de préférence comprise entre 2 mm et 3 mm.

10. Ensemble (100) selon l'une des revendications précédentes,
dans lequel une première section transversale (A1) de la première section de connexion (11) dans un plan parallèle au plan d'extension principale (M) est supérieure à une deuxième section transversale (A2) de l'élément de contact dans un plan parallèle au plan d'extension principale (M).

11. Dispositif selon la revendication 10,
dans lequel l'élément de contact et l'autre élément de contact sont situés entre la première section de connexion (11) et la deuxième section de connexion (21).

12. Procédé de connexion d'un composant électrique à une barre omnibus (1) pour former un ensemble (100) selon l'une des revendications précédentes.

13. Procédé selon la revendication 12,
dans lequel un élément de contact d'un composant électronique est inséré dans une zone d'enfichage (30) de la barre omnibus (1), l'élément de contact étant brasé et/ou soudé à la section de connexion (11), de préférence automatiquement par un robot.

14. Procédé selon l'une des revendications 12 ou 13,
dans lequel plusieurs éléments de contact sont brasés et/ou soudés simultanément.

15. Procédé selon l'une des revendications 12 à 14,
dans lequel l'élément de contact est relié à la première section de connexion (11) par brasage à la vague, brasage par résistance, brasage manuel au fer à braser et/ou soudage par pointe.
